(19) Europäisches Patentamt
European Patent Office
Office européen des brevets

(11) Publication number: **0 096 122**
**B1**

(12) **EUROPEAN PATENT SPECIFICATION**

(45) Date of publication of patent specification: **24.09.86**

(51) Int. Cl.$^4$: **C 08 L 81/02**, B 32 B 17/04, H 05 K 1/02

(21) Application number: **82302887.3**

(22) Date of filing: **04.06.82**

(54) **Reinforced polyphenylene sulphide board, printed circuit board made therefrom and process for making them.**

(43) Date of publication of application:
**21.12.83 Bulletin 83/51**

(45) Publication of the grant of the patent:
**24.09.86 Bulletin 86/39**

(84) Designated Contracting States:
**DE FR GB**

(56) References cited:
**US-A-3 953 653**
**US-A-4 017 450**
**US-A-4 115 344**

**CHEMICAL ABSTRACTS, vol. 97, no. 76, 1982, page 735, no. 173581w, Columbus, Ohio, USA ELSEVIER, 1972, pages 360-363**

(73) Proprietor: **TORAY INDUSTRIES, INC.**
**2, Nihonbashi-Muromachi 2-chome Chuo-ku**
**Tokyo 103 (JP)**

(72) Inventor: **Kitanaka, Minoru**
**1-81, Ikegamidai Midori-ku**
**Nagoya-shi Aichi-ken (JP)**
Inventor: **Deguchi, Yukichi**
**2-10, Sonoyama**
**Otsu-shi Shiga-ken (JP)**

(74) Representative: **Ellis, John Clifford Holgate et al**
**MEWBURN ELLIS & CO. 2/3 Cursitor Street**
**London EC4A 1BQ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 096 122 B1

**Description**

Background of the invention

(1) Field of the invention

This invention relates to a printed circuit board having as substrate a reinforced polyphenylene sulfide (hereinafter referred to as "PPS" for brevity) molded board which is excellent in the mechanical properties such as the inpact resistance and the thermal properties such as the heat distortion temperature and solder resistance, and which provides a very strong adhesion to a metallic foil even without using an adhesive and to a process for preparing this printed circuit board with ease and at low costs.

(2) Description of the prior art

So-called printed circuit boards comprising an insulating substrate and a conductor composed of a metallic foil such as a copper foil, which is flatly bonded onto the substrate, are used in large quantities for electric circuits in various houshold electric appliances, electronic computers, communication facilities and various meters and instruments.

As the insulating substrate for a printed circuit board, there has heretofore been used a composite sheet formed by combining a thermosetting resin such as an epoxy resin, a phenol resin or an unsaturated polyester resin with a base sheet composed of paper, glass fibers or synthetic fibers. These composite sheets are prepared by a process wherein a base sheet composed of paper, glass fibers or synthetic fibers is coated or impregnated with a resin solution so-called "varnish", which is formed by dissolving a thermosetting resin in a solvent; the coated or impregnated base sheet is heated in a drier, thereby to vaporize the solvent in the varnish and remove the solvent and to effect polymerization of the resin to form a prepreg of the so-called B-stage; a predetermined number of the so-formed prepregs are superposed upon another and compressed under heating to cure the resin. However, in this process, since it is necessary to remove the solvent from the varnish applied to the base sheet, large expenses are required for recovery and treatment of the solvent. Furthermore, the solvent is scattered in the open air and the working environment is drastically polluted. Moreover, a long time is required for curing the resin. Accordingly, this process is disadvantageous from the economical viewpoint.

It is known that a thermoplastic resin such as polyethylene, polytetrafluoroethylene or polyphenylene oxide may also be used as the insulating substrate for a printed circuit board. However, none of these thermoplastic resins can provide printed circuit boards which are satisfactorily balanced among the thermal properties, the mechanical properties, the chemical resistance and the manufacturing costs.

Japanese Patent Laid-open Application (JP—A) No. 85,380/79 proposes a printed circuit board comprising as an insulating substrate a molded board comprising PPS, which is excellent by itself in the heat resistance, the chemical resistance, the electric properties and the flame retardancy, and glass fibers (hereinafter referred to as "GF" for brevity) having a length smaller than 3 mm, and a metallic foil bonded to said substrate through an epoxy type adhesive. However, this printed circuit board is poor in the mechanical properties and is especially poor in the resistance to the soldering operation indispensable for processing and attachment of the printed circuit board, that is, the solder resistance. Moreover, the process for preparing this printed circuit board involves various complicated steps such as the steps of mixing PPS with GS, the melt-kneading step, the injection molding step, the adhesive-coating step and the metal foil-bonding step, and the obtained printed circuit board is very expensive.

It is therefore a primary object of the present invention to provide a printed circuit board which is well-balanced among mechanical properties such as the impact resistance, thermal properties such as the heat distortion temperature and solder resistance, chemical resistance, the electric properties, flame retardancy and the bonding strength between the substrate and metallic foil.

Another object of the present invention is to provide a process for preparing the above-mentioned excellent printed circuit board at low cost by simplified process steps.

According to the present invention a printed circuit board comprising as an insulating substrate a reinforced polyphenylene sulfide molded board incorporating glass fibers and a metallic foil bonded to the surface of the substrate, is characterised in that:

(a) the substrate comprises 20—85% by weight of polyphenylene sulfide and 80—15% by weight of glass fibers;

(b) the polyphenylene sulfide has a degree of crystallinity of at least 40%; and

(c) the glass fibers have a length of at least 5 mm.

In accordance with another aspect of the invention, a process for the preparation of such a printed circuit board comprises compressing under heating a mixture or laminate comprising 20 to 85% by weight of polyphenylene sulfide and 15 to 80% by weight of glass fibers having a length of at least 5 mm to form a composite molded board, cooling the composite molded board under pressure under time/temperature conditions such as to ensure a degree of crystallinity of at least 40% and, at or after the step of forming the molded board, bonding a metallic foil to a surface of the board, glass fibers having a length of at least 5 mm to form a composite molded board, and, at or after the compression step, bonding a metallic foil to the surface of the molded board.

Detailed description of the preferred embodiments

Since the printed circuit board of the present invention is prepared from PPS and GF without subjecting the mixture of PPS and GF to the melt-kneading step, the process steps can be simplified, and since GF contained in the obtained printed circuit board retains a length of at least 5 mm, the reinforcing efficiency is high and the mechanical properties such as the impact resistance are very high. Furthermore, the printed circuit board of the present invention is excellent in the solder resistance over the conventional printed circuit board comprising as an insulating substrate a PPS molded board comprising GF having a length smaller than 3 mm, and therefore, an effect of providing a high adhesion between the substrate and metallic foil without using an adhesive can be attained according to the present invention.

PPS that is used in the present invention is a polymer comprising at least 90 mol%, preferably at least 95 mol%, of repeating units represented by the structural formula

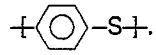.

If the content of the above repeating units (units of phenylene sulfide of the para-linkage) is lower than 90 mol%, the crystallinity of the polymer is insufficient and the rigidity and heat distortion temperature are reduced. PPS that is used in the present invention may comprise up to 10 mol% of repeating units represented by the structural formula:

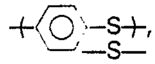, 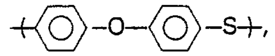, 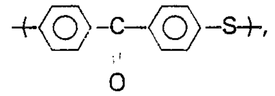,

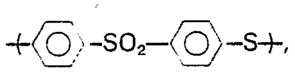, 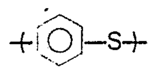 or 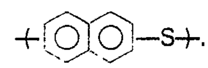.

It is preferred that PPS used in the present invention should have a melt viscosity of 50 to 50,000 poises, especially 100 to 5,000 poises, as determined at a temperature of 300°C and an apparent shear rate of 200 $sec^{-1}$. If the melt viscosity is lower than 50 poises, satisfactory mechanical strength and impact resistance cannot be obtained. If the melt viscosity is higher than 50,000 poises, when GF is combined with PPS, voids among GF are not sufficiently filled with PPS and attainment of the desired mechanical strength cannot be expected.

Ordinary additives such as an antioxidant, a heat stabilizer, a lubricant, a crystal nucleating agent, an utraviolet absorber, a coloring agent, a filler and a parting agent may be incorporated into PPS used in the present invention. Furthermore, a small amount of other polymer may be blended in PPS used in the present invention, so far as attainment of the objects of the present invention is not inhibited.

The form of GF used in the present invention is not particularly limited, so far as the length of GF is at least 5 mm. For example, GF may be used in the form of a chopped fiber, a chopped fiber mat, a continuous filament mat, a woven fabric, a knitted fabric or a combination of two or more of them. In the present invention, it is preferred that GF be used in the form of a mat or a fabric such as a woven or knitted fabric.

Factors important for obtaining a printed circuit board having good heat resistance, mechanical strength and bonding strength are the length and content of GF contained in the insulating substrate and the degree of crystallinity of PPS. GF having a length of at least 5 mm should be contained in an amount of 15 to 80% by weight, preferably 20 to 75% by weight. If the length of GF is smaller than 5 mm or the content of GF is lower than 15% by weight, no satisfactory mechanical properties can be obtained. If the content is higher than 80% by weight, the mechanical properties are rather reduced.

It is preferred that the degree of crystallinity of the PPS matrix in the insulating substrate be at least 40%, especially at least 50%. This degree of crystallinity is important in the case where the glass fiber-reinforced PPS molded board is used as an insulating substrate of a printed circuit board. This is because, if the degree of crystallinity is lower than 40%, deformation is large under heating and the heat resistance is insufficient. It is preferred that the degree of crystallinity be not more than about 75%. If the degree of crystallinity exceeds about 75%, a substantially long period of time is necessary for crystallization.

Incidentally, the degree of crystallinity herein referred to is determined according to the X-ray diffraction method (see Masao Kakudo, "Polymer X-Ray Diffractometry", pages 262—265). More specifically, in the line profile of X-ray diffraction a base line is drawn and a gentle curve is drawn along the skirt portion of the line profile of X-ray diffraction, in order to divide the diffraction intensity into crystalline diffraction and amorphous halo. Since the intensity of amorphous halo corresponding to GF in the sample is much smaller than the intensity of amorphous PPS halo, the amorphous halo from GF is neglected and correction is not conducted.

When a customary method wherein a chopped fiber of GF and powdery or granular PPS is melt-extruded by an extruder or a method wherein pellets prepared by the above method or a mixture of a chopped fiber of GF and PPS is injection molded is adopted as means for obtaining a reinforced PPS molded board (insulating substrate) or a printed circuit board of the present invention, the length of GF is shortened to less than 3 mm, particularly less than 0.5 mm, by a shearing force imposed at the

melt-kneading or injection molding step, and therefore, the resulting molded board becomes poor in impact strength, and comes to have anisotropic characteristics and readily warp.

Accordingly, as means for obtaining a reinforced PPS molded baord or printed circuit board of the present invention in which the length of GF is at least 5 mm, especially 1.0 cm, and a high impact resistance is maintained, there should be adopted a method in which integration of PPS with GF is accomplished only by compression under heating while avoiding application of a shearing force. Specifically, the following five methods (1) through (5) can be mentioned.

(1) A chopped glass fiber having a length of at least 5 mm, preferably a chopped glass fiber to which a sizing agent has not been applied, is mixed with powdery PPS at a predetermined ratio; the mixture is blended by a Henschel mixer under conditions not causing cutting of GF, for example, at a number of revolution of 500 to 2,000 rpm for about 5 to about 20 minutes; the resulting fibrous mixture is compression-molded in a mold heated at a temperature higher than the melting point of PPS, ordinarily at 290 to 330°C; and then, the molded article is cooled to a temperature lower than the melting point of PPS ordinarily to 150 to 200°C, and then is withdrawn.

(2) A chopped glass fiber similar to that mentioned above with respect to the method (1) is interposed between PPS sheets, and the assembly is compression-molded in the same manner as in the method (1).

(3) A predetermined amount of powdery PPS is scattered to a GF fabric such as a chopped glass fiber mat, a continuous glass filament mat or a woven or knitted fabric of GF, and the fabric having the PPS powder is compression-molded in the same manner as in the method (1).

(4) One or more GF fabrics similar to those used in the method (3) and one or more PPS sheets are alternately superposed upon another, and the assembly is compression-molded in the same manner as in the method (1).

(5) A mixture or assembly of PPS with GF, similar to those which are mentioned in the method (1), (2), (3) or (4) is introduced between a pair of metal belts where said mixture or assembly is continuously heated and cooled under pressure to form a composite molded board.

Among these methods (1) through (5), the methods (3), (4) and (5) are preferable from the viewpoint of the process efficiency, and the method (5) is especially preferable because a high manufacturing efficiency can be attained.

In the method (5), the heating temperature is ordinarily 290 to 330°C, and the pressure is 10 to 150 kg/cm$^2$. The cooling temperature is in the range of from about 120°C at which PPS can be crystallized with a degree of crystallinity of at least 40%, to the melting point (about 285°C), preferably in the range from 140 to 240°C.

The foregoing methods are advantageous over the conventional method using a varnish of an epoxy resin or phenolic resin, because a good insulating substrate can be obtained only by melting PPS, impregnating GF with the molten PPS and then cooling the impregnated GF under pressure and the operation efficiency is increased since the steps of recovering and treating the solvent and curing the resin become unnecessary.

The thickness of the molded board to be used as an insulating substrate in the present invention is not particularly critical, but ordinarily, the thickness is adjusted to 0.05 to 5.0 mm. If desired, in order to increase the thickness of the molded board, a sheet composed of other resin may be laminated on one surface of the molded board according to the present invention.

The heat distortion temperature of the so-obtained molded board as determined under a load of 18.6 kg/cm$^2$ according to the method of ASTM D-648 is extremely high and is in the range of from 260 to 285°C, and the molded board is excellent in not only the heat resistance and solder resistance but also the mechanical strength. Accordingly, the molded board is useful especially as an insulating substrate for a printed circuit board.

The molded board of the present invention can be shaped into molded articles such as a tray, a cup and a dome by a process wherein the molded board is heated at a temperature higher than the melting point of PPS, and then, compression-molded in a mold maintained at a temperature below the melting point of PPS.

As the metallic foil to be bonded to the insulating substrate for the preparation of the printed circuit board of the present invention, there can be mentioned a copper foil, an aluminum foil and a silver foil. Of these, a copper foil is especially preferred.

Bonding of the metallic foil to the insulating substrate can be accomplished simultaneously with the integration of PPS with GF in any of the foregoing methods (1) through (5) or at any optional stage after the integration. In view of the simplicity of the process, it is preferred that the bonding be carried out simultaneously with the integration. The means for bonding the metallic foil to the insulating substrate to form a conductor layer is not particularly critical. For example, there can be adopted a so-called substractive method wherein a metallic foil is bonded to the surface of the insulating substrate and then, the metallic foil is pattern-etched, an additive method wherein copper or the like is deposited in the form of a pattern on the insulating substrate, and a stamping foil method wherein a copper foil or the like stamped in the form of a pattern is bonded to the insulating substrate.

When the metallic foil is bonded to the insulating substrate in the present invention, a good adhesion can be obtained even without using an adhesive. However, if an epoxy type adhesive, a silane type adhesive, an epoxy-silane type adhesive or an isocyanate type adhesive is used according to need, a further improved adhesion can be obtained.

The printed circuit board prepared according to the simplified process of the present invention has excellent thermal and mechanical properties and a good solder resistance, and therefore, application of this printed circuit board to electric and electronic industries is very promising.

The present invention will now be described in detail with reference to the following Examples that by no means limit the scope of the invention. In the Examples, parts are by weight.

Example 1

An autoclave was charged with 32.6 kg (250 mols; 40% by weight of water of crystallization contained) of sodium sulfide, 100 g of sodium hydroxide, 36.1 kg (250 mols) of sodium benzoate and 79.2 kg of N-methyl-2-pyrrolidone (hereinafter referred to as "NMP"), and the temperature was gradually elevated to 205°C to distill off 7.0 l of a distillate containing 6.9 kg of water. To the residual mixture were added 37.5 kg (255 mols) of 1,4-dichlorobenzene and 20.0 kg of NMP, and the mixture was maintained at 265°C for 4 hours. The reaction product was washed with hot water 8 times and dried at 80°C for 24 hours in a vacuum dried to obtain 21.1 kg of powdery, highly polymeric PPS having a melt viscosity of 2,900 poises.

A sheet having a thickness of 0.7 mm was prepared from this PPS by extrusion. Then, two of the so-prepared sheets and two continuous glass filament mats ("M9600" supplied by Asahi Fiber Glass K.K.; basis weight=600 g/m$^2$) were alternately superposed upon another and the assembly was supplied into a flat die mold placed in a heating press maintained at 330°C where the assembly was pressed for 3 minutes under a pressure of 5 kg/cm$^2$. The mold was transferred into a cooling press maintained at 150°C, and the assembly was cooled for 5 minutes under a pressure of 35 kg/cm$^2$ to obtain a continuous glass filament-reinforced PPS molded board (A) having a thickness of 1.6 mm.

The powdery PPS obtained according to the above-mentioned method and a chopped glass fiber having a length of 3, 6 or 15 mm ("CS03MA411", "CS06MA411" or "CS15MA411" supplied by Asahi Fiber Glass K.K.) were mixed for 20 minutes in a Henschel mixer so that the amount of the glass fiber incorporated was 40% by weight, to obtain a fibrous mixture comprising the powdery PPS and chopped glass fiber. The mixture was supplied to a heating press where the mixture was press-molded, and then, cooled under the same conditions as described above to obtain a molded board (B), (C) or (D) having a thickness of 1.6 mm.

Separately, an adhesive comprising 70 parts of a polyester amide resin consisting of 40% by weight of butylene terephthalate units, 27% by weight of butylene isophthalate units and 33% by weight of dodecanamide and 30 parts of a bisphenol type epoxy resin in a mixed solvent of monochlorobenzene and methanol was coated and dried on a commercially available electrolytic copper foil for a printed circuit (35 mm in thickness) to form an adhesive-coated copper foil.

The so-prepared adhesive-coated copper foil was superposed on the above-mentioned molded board, and the assembly was compressed at 130°C to thermally cure the adhesive and obtain a copper clad laminate (printed circuit board). The properties of the so-obtained copper clad laminate were determined according to JIS C-6481. The obtained results are shown in Table 1.

For comparison, the powdery PPS obtained according to the above-mentioned method was mixed with 40% by weight of a chopped glass fiber having a length of 3 or 9 mm, and the mixture was homogeneously blended by an extruder. The obtained pellet was supplied to an injection molding machine where the pellet was molded at a mold temperature of 120°C to obtain a molded board (E) or (F) having a size of 1.6 mm×160 mm×120 mm. A copper clad laminate was prepared from the so-obtained molded board in the same manner as described above. The properties were determined to obtain results shown in Table 1.

The properties shown in Table 1, except the solder resistance and the peel strength, are those determined with respect to the substrate left after removal of the copper foil by etching.

The glass fiber length shown in Table 1 is the value determined by the microscopic and naked eye observation of the ash left after burning of the molded board. From the data of the glass fiber length, it is seen that in each of the molded boards (A), (B), (C) and (D), the glass fiber was contained in the molded board while retaining its original length, but in each of the molded boards (E) and (F) prepared through extrusion and injection molding, the glass fiber was cut into a length shorter than 0.3 mm.

From the results shown in Table 1, it is seen that when the length of the glass fiber is smaller than 5 mm [molded boards (B), (E) and (F)], the solder resistance and heat resistance are poor and the flexural strength is extremely low, whereas in the printed circuit board of the present invention [molded boards (A), (C) and (D)], these defects are eliminated.

TABLE 1

| Run No. | Molded board | Glass fiber: Content[a] (% by weight) | Glass fiber: Length[b] (mm) | Degree of crystallinity[c] (%) | Heat resistance: Heat distortion temperature[d] (°C) | Heat resistance: Solder resistance[e] | Flexural strength[f] ($kg/mm^2$) | Peel strength[g] (kg/cm) |
|---|---|---|---|---|---|---|---|---|
| 1 (comparison) | (B) | 40 | 3 | 51 | 258 | Blistered | 13 | 1.6 |
| 2 (comparison) | (E) | 41 | Below 0.3 | 53 | 245 | Extremely warped | 12 | 1.5 |
| 3 (comparison) | (F) | 40 | Below 0.3 | 52 | 246 | " | 11 | 1.6 |
| 4 (present invention) | (C) | 40 | 6 | 52 | 280 | Good | 20 | 1.6 |
| 5 (present invention) | (D) | 40 | 15 | 54 | 280 | Good | 23 | 1.7 |
| 6 (present invention) | (A) | 39 | Continuous filament | 53 | 281 | Good | 20 | 1.6 |

Note
[a] determined from ash content
[b] determined by microscopic and naked eye observation of ash
[c] determined by using X-ray diffractometer (Model D-3F supplied by Rigaku Denki K.K.) and CuKα (33 KV, 12 mA, Ni filter)
[d] determined under load of 18.6 $kg/cm^2$ according to ASTM D-648
[e] evaluated by change of appearance after 30 seconds' dipping in soldering bath at 260°C
[f] determined according to ASTM D-790
[g] determined according to JIS C-6481

Example 2

One to three of PPS extruded sheets prepared in the same manner as described in Example 1, one to four of continuous glass filament mats and one copper foil were superposed upon another so that the copper foil was located as the outermost layer and directly contacted with a PPS sheet and the glass fiber content was as indicated in Table 2. The assembly was supplied into a flat mold die maintained at room temperature, and the mold was placed in a heating press maintained at 330°C under a pressure of 10 kg/cm$^2$ for 15 minutes. Then, the mold was transferred to a cooling press maintained at 150°C and was cooled under a pressure of 100 kg/cm$^2$ for 10 minutes to obtain a copper clad laminate (printed circuit board) having a thickness of 1.2 to 1.5 mm and a good appearance. The properties of the laminated board were determined in the same manner as described in Example 1. The obtained results are shown in Table 2.

From the results shown in Table 2, it is seen that in the printed circuit board of the present invention (Runs Nos. 8 and 9), good properties were obtained even without using an adhesive, whereas if the glass fiber content was lower than 15% by weight (Run No. 7), the heat resistance and flexural strength were drastically reduced.

TABLE 2

| Run No. | Glass fiber | | Degree of crystallinity (%) | Heat resistance | | Flexural strength ($kg/mm^2$) | Peel strength (kg/cm) |
|---|---|---|---|---|---|---|---|
| | Content (% by weight) | Length (mm) | | Heat distortion temperature (°C) | Solder resistance | | |
| 7 (comparison) | 9.5 | Continuous filament | 55 | 245 | Warped and blistered | 9.5 | 1.6 |
| 8 (present invention) | 17 | " | 54 | 263 | Good | 12 | 1.7 |
| 9 (present invention) | 30 | " | 53 | 280 | Good | 15 | 1.5 |
| 10 (present invention) | 38 | " | 53 | 281 | Good | 19 | 1.5 |

Example 3

A sheet having a thickness of 1.0 mm was prepared from the powdery PPS obtained in Example 1 according to the extrusion method. Two of the so-prepared sheets and two of the same continuous glass filament mats as used in Example 1 were alternately superposed upon another, and procedures of Example 2 were repeated in the same manner except that the cooling press temperature was varied to a temperature ranging from the water-cooling temperature (i.e., about 20°C) to 200°C, to obtain a copper clad laminate (printed circuit board) having a degree of crystallinity shown in Table 3 and a thickness of 2.0 mm. The heat resistance and flexural strength and other properties were determined to obtain results shown in Table 3.

From the results shown in Table 3, it is seen that when the degree of crystallinity was lower than 40% (Runs Nos. 11 and 12), the heat resistance was extremely reduced.

TABLE 3

| Run No. | Glass fiber | | Cooling press temperature (°C) | Degree of crystallinity (%) | Heat distortion temperature (°C) | Heat resistance | | Flexural strength ($kg/mm^2$) | Peel strength (kg/cm) |
|---|---|---|---|---|---|---|---|---|---|
| | Content (% by weight) | Length (mm) | | | | Solder resistance | Naked eye observation[a] | | |
| 11 (comparison) | 30 | Continuous filament | Water cooling | 5 | 162 | Extremely warped | Extremely warped | 14 | 2.0 |
| 12 (comparison) | 30 | " | 80 | 9 | 204 | Warped and blistered | Warped | 18 | 2.1 |
| 13 (present invention) | 30 | " | 130 | 41 | 278 | Good | No change | 15 | 1.8 |
| 14 (present invention) | 30 | " | 160 | 55 | 278 | Good | " | 15 | 1.5 |
| 15 (present invention) | 30 | " | 200 | 60 | 280 | Good | " | 16 | 1.6 |

Note
[a] Sample was maintained at 130°C for 30 minutes and thereafter appearance was observed by naked eye (other properties were determined in the same manner as in Table 1).

Example 4

Powdery PPS having an apparent melt viscosity of about 4,000 poises ("RYTON P-4" supplied by Phillips Petroleum Co.) was uniformly scattered on continuous glass filament mats ("M9600" supplied by Asahi Fiber Glass K.K.; basis weight=600 g/$m^2$), and two of these glass filament mats were superposed upon another and a copper foil having a thickness of 35 μ was further superposed as an outermost layer on the mats. The assembly was supplied into a pair of endless metal belts and was continuously heated and cooled under pressure to obtain a copper clad laminate having a thickness of 2.0 mm and comprising an insulating substrate of glass fiber-reinforced PPS. The molding conditions were as follows.

| | |
|---|---|
| Heating zone temperature: | 325°C |
| Cooling zone temperature: | 120°C |
| Belt travelling speed: | 0.33 m/min |
| Maximum temperature of central portion of product: | 298°C |
| Temperature at withdrawal of product: | 180°C |

In the obtained copper clad laminate (printed circuit board), the glass fiber content in the insulating substrate was 37% by weight, the degree of crystallinity was 57%, the heat distortion temperature was 280°C and the flexural strength was 21 kg/$mm^2$. Thus, it was confirmed that the laminate was excellent in the heat resistance and mechanical properties. Furthermore, other characteristics of the laminate were determined according to JIS (Japanese Industrial Standard) C-6481 to obtain results shown in Table 4.

TABLE 4

| Item | Treatment | Characteristic value |
|---|---|---|
| Adhesion (kg/cm) | A | 1.8 |
| Solder resistance (260°C, seconds) | A | More than 30 |
| Surface resistivity (Ω) | C−96/25/65+C−96/40/90 | $5\times10^{14}$ |
| Chemical resistance<br>Trichloroethylene | Boiled, 5 minutes | No change |
| Methylene chloride | Room temperature, 10 minutes | " |
| MEK | " | " |
| Methanol | " | " |
| Hydrochloric acid (10%) | " | " |
| Potassium cyanide (10%) | 70°C, 30 minutes | Less than 10%* |

* percent of reduction of adhesion.

Example 5

The same powdery PPS as used in Example 4 was uniformly scattered on glass cloths ("H252" supplied by Asahi Fiber Glass K.K.), and two of these cloths were superposed upon another and placed in a flat die mold in a heating press maintained at 330°C. The assembly was pressed under a pressure of 5 kg/$cm^2$ at that temperature for 3 minutes. Then, the mold was transferred into a cooling press maintained at 150°C, and the pressed assembly was cooled for 5 minutes under a pressure of 35 kg/$cm^2$ to obtain a glass cloth-reinforced molded board having a thickness of 0.65 mm.

An electrolytic copper foil for a printed circuit (35 μ in thickness) was superposed on one surface of the so-obtained molded board and the laminate was supplied in a flat die mold placed in a heating press maintained at 310°C, where the laminate was pressed for 3 minutes under a pressure of 10 kg/$cm^2$. The mold was transferred into a cooling press maintained at 150°C and the pressed laminate was cooled for 10 minutes under a pressure of 100 kg/$cm^2$.

The properties of the resulting copper clad laminate were determined to obtain results shown in Table 5.

TABLE 5

| Item | Treatment | Characteristic value |
|---|---|---|
| Adhesion (kg/cm) | A | 1.9 |
| Solder resistance (260°C, seconds) | A | More than 30 |
| Surface resistivity (Ω) | C−96/25/65+C−96/40/90 | $7\times10^{14}$ |
| Chemical resistance | | |
| Trichloroethylene | Boiled, 5 minutes | No change |
| Methylene chloride | Room temperature, 10 minutes | " |
| MEK | " | " |
| Methanol | " | " |
| Hydrochloric acid (10%) | " | " |
| Potassium cyanide (10%) | 70°C, 30 minutes | Less than 10%* |

*percent of reduction of adhesion

**Claims**

1. A printed circuit board comprising as an insulating substrate a reinforced polyphenylene sulfide molded board incorporating glass fibers and a metallic foil bonded to the surface of the substrate, characterised in that

(a) the substrate comprises 20—85% by weight of polyphenylene sulfide and 80—15% by weight of glass fibers;

(b) the polyphenylene sulfide has a degree of crystallinity of at least 40%; and

(c) the glass fibers have a length of at least 5 mm.

2. A printed circuit board according to claim 1, wherein the glass fibers are chopped glass fibers.

3. A printed circuit board according to claim 1 or claim 2, wherein the glass fibers are in the form of a mat, or a woven fabric, or a knitted fabric.

4. A printed circuit board according to any one of the preceding claims, wherein the content of the glass fibers in the molded board is 20 to 75% by weight.

5. A printed circuit board according to any one of the preceding claims, wherein the degree of crystallinity of polyphenylene sulfide is at least 50%.

6. A process for the preparation of a printed circuit board according to claim 1 which comprises compressing under heating a mixture or laminate comprising 20 to 85% by weight of polyphenylene sulfide and 15 to 80% by weight of glass fibers having a length of at least 5 mm to form a composite molded board, cooling the composite molded board under pressure under time/temperature conditions such as to ensure a degree of crystallinity of at least 40% and, at or after the step of forming the molded board, bonding a metallic foil to a surface of the board.

7. A process for the preparation of printed circuit boards according to claim 6, wherein the polyphenylene sulfide/glass fiber mixing ratio is in the range of from 25/75 to 80/20 by weight.

8. A process for the preparation of printed circuit boards according to claim 6 or claim 7, wherein the mixture of powdery polyphenylene sulfide and chopped glass fibers is placed into a mold where the mixture is compressed under heating to be thereby integrated.

9. A process for the preparation of printed circuit boards according to claim 6 or claim 7, wherein a laminate comprising chopped glass fibers interposed between polyphenylene sulfide sheets is placed in a mold where the laminate is compressed under heating to be thereby integrated.

10. A process for the preparation of printed circuit boards according to claim 6 or claim 7, wherein powdery polyphenylene sulfide is uniformly scattered on a mat, woven fabric or knitted fabric of glass fibers, and the mat, woven fabric or knitted fabric is placed in a mold where the mat or woven or knitted fabric is compressed under heating to be thereby integrated.

11. A process for the preparation of printed circuit boards according to claim 6 or claim 7, wherein a laminate comprising one or more mats, woven fabrics or knitted fabrics of glass fibers and one or more polyphenylene sulfide sheets is compressed in a mold under heating to be thereby integrated.

12. A process for the preparation of printed circuit boards according to claim 6 or claim 7, wherein the mixture or laminate of the polyphenylene sulfide and the glass fibers is placed between a pair of metal belts and is continuously heated under application of a pressure to effect the integration.

13. A process for the preparation of printed circuit boards according to any one of claims 6 to 12, wherein the metallic foil is bonded to the surface of the molded board simultaneously with the compression under heating.

14. A process for the preparation of printed circuit boards according to any one of claims 6 to 12, wherein the metallic foil is bonded to the surface of the molded board after the compression under heating.

15. A process for the preparation of printed circuit boards according to any one of claims 6 to 14, wherein the heating temperature is higher than the melting point of polyphenylene sulfide.

**Patentansprüche**

1. Gedruckte Schaltungsplatte, die als isolierenden Träger eine verstärkte Polyphenylensulfidplatte enthält, in welche Glasfasern sowie eine mit der Trägeroberfläche verbundene Metallfolie eingebracht sind, dadurch gekennzeichnet, daß

(a) der Träger 20 bis 85 Gew.-% Polyphenylensulfid und 80 bis 15 Gew.-% Glasfasern enthält; daß

(b) das Polyphenylensulfid einen Kristallinitätsgrad von mindestens 40% hat; und daß

(c) die Glasfasern eine Länge von mindestens 5 mm haben.

2. Gedruckte Schaltungsplatte nach Anspruch 1, wobei die Glasfasern geschnittene Glasspinnfasern sind.

3. Gedruckte Schaltungsplatte nach Anspruch 1 oder Anspruch 2, wobei die Glasfasern die Form einer Matte oder eines Gewebes oder eines Gewirkes haben.

4. Gedruckte Schaltungsplatte nach einem der vorhergehenden Ansprüche, wobei der Gehalt an Glasfasern in der ausgeformten Platte 20 bis 75 Gew-% beträgt.

5. Gedruckte Schaltungsplatte nach einem der vorhergehenden Ansprüche, wobei der Kristallinitätsgrad des Polyphenylensulfids mindestens 50% beträgt.

6. Verfahren zur Herstellung einer gedruckten Schaltungsplatte nach Anspruch 1, bei dem unter Erhitzen ein Gemisch oder ein Laminat, das aus 20 bis 85 Gew.-% Polyphenylensulfid und 15 bis 80 Gew.-% Glasfasern mit einer Länge von mindestens 5 mm besteht, unter Ausbilden einer zusammengesetzten, ausgeformten Platte gepreßt wird, bei dem die zusammengesetzte, ausgeformte Platte unter Druck und solchen Zeit/Temperaturbedingungen ausgeformt wird, daß ein Kristallinitätsgrad von mindestens 40% gewährleistet ist, und bei dem während oder nach der Ausbildungsstufe der ausgeformten Platte eine Metallfolie an die Oberfläche der Platte gebunden wird.

7. Verfahren zur Herstellung von gedruckten Schaltungsplatten nach Anspruch 6, bei dem das Polyphenylensulfid/Glasfaser-Mischungsverhältnis im Bereich von 25/75 bis 80/20 Gew.-% liegt.

8. Verfahren zur Herstellung von gedruckten Schaltungsplatten nach Anspruch 6 oder Anspruch 7, bei dem ein Gemisch von pulverförmigem Polyphenylensulfid und geschnittenen Glasspinnfasern in eine Form eingebracht wird, in der das Gemisch unter Erhitzen zum Integrieren gepreßt wird.

9. Verfahren zur Herstellung von gedruckten Schaltungsplatten nach Anspruch 6 oder Anspruch 7, bei dem ein aus geschnittenen Glasspinnfasern, die zwischen Polyphenylensulfidfilmen eingelegt sind, bestehendes Laminat in eine Form eingebracht wird, in der es unter Erhitzen zum Integrieren gepreßt wird.

10. Verfahren zur Herstellung von gedruckten Schaltungsplatten nach Anspruch 6 oder Anspruch 7, bei dem pulverförmiges Polyphenylensulfid einheitlich auf eine Matte, ein Gewebe oder ein Gewirk aus Glasfasern gestreut und die Matte, das Gewebe oder das Gewirk in eine Form eingebracht wird, wo die Matte, das Gewebe oder das Gewirk unter Erhitzen zum Integrieren gepreßt wird.

11. Verfahren zur Herstellung von gedruckten Schaltungsplatten nach Anspruch 6 oder Anspruch 7, bei dem ein aus einer oder mehreren Matten, Geweben oder Gewirken aus Glasfasern sowie ein oder mehreren Polyphenylensulfidfilmen bestehendes Laminat in einer Form unter Erhitzen zum Integrieren gepreßt wird.

12. Verfahren zur Herstellung von gedruckten Schaltungsplatten nach Anspruch 6 oder Anspruch 7, bei dem das Gemisch oder das Laminat von Polyphenylensulfid und Glasfasern zwischen ein Paar von Metallbändern gelegt und unter Anwendung von Druck zum Integrieren kontinuierlich erhitzt wird.

13. Verfahren zur Herstellung von gedruckten Schaltungsplatten nach einem der Ansprüche 6 bis 12, bei dem die Metallfolie gleichzeitig mit dem Pressen unter Erhitzen an die Oberfläche der ausgeförmten Platte gebunden wird.

14. Verfahren zur Herstellung von gedruckten Schaltungsplatten nach einem der Ansprüche 6 bis 12, bei dem die Metallfolie nach dem Pressen unter Erhitzen an die Oberfläche der ausgeformten Platte gebunden wird.

15. Verfahren zur Herstellung von gedruckten Schaltungsplatten nach einem der Ansprüche 6 bis 14, bei dem die Erhitzungstemperatur oberhalb des Schmelzpunktes von Polyphenylensulfid liegt.

**Revendications**

1. Plaque de circuit imprimé, comprenant comme substrat isolant une plaque en sulfure de polyphénylène moulée et renforcée par incorporation de fibres de verre et une feuille métallique adhérant à la surface du substrat, plaque caractérisée en ce que:

(a) la substrat comporte 20 à 85% en poids de sulfure de polyphénylène et 80 à 15% en poids de fibres de verre;

(b) le sulfure de polyphénylène présente un degré de cristallinité d'au moins 40%; et

(c) les fibres de verre ont une longueur d'au moins 5 mm.

2. Plaque de circuit imprimé selon la revendication 1, dans laquelle les fibres de verre sont des fibres de verre hachées.

3. Plaque de circuit imprimé selon la revendication 1 ou la revendication 2, dans laquelle les fibres de verre sont sous la forme d'un mat, ou d'une étoffe tissée ou d'une étoffe tricotée.

4. Plaque de circuit imprimé selon l'une quelconque des revendications précédentes, dans laquelle la teneur en fibres de verre de la plaque moulée se situe entre 20 et 75% en poids.

5. Plaque de circuit imprimé selon l'une quelconque des revendications précédentes, dans laquelle le degré de cristallinité du sulfure de polyphénylène est d'au moins 50%.

6. Procédé pour préparer une plaque de circuit imprimé selon la revendication 1, qui comprend la compression sous chauffage d'un mélange ou stratifié comprenant 20 à 85% en poids de sulfure de polyphénylène et 15 à 80% en poids de fibres de verre ayant une longueur d'au moins 5 mm, pour former une plaque moulée composite, le refroidissement de la plaque moulée composite sous pression et dans des conditions de temps/température garantissant l'obtention d'un degré de cristallinité d'au moins 40% et, pendant ou après l'étape de formation de la plaque moulée, le collage d'une feuille métallique mince sur une surface de la plaque.

7. Procédé pour la préparation de plaques de circuits imprimés selon la revendication 6, dans lequel le rapport de mélange sulfure de polyphénylène/fibres de verre se situe entre 25/75 et 80/20 en poids.

8. Procédé pour la préparation de plaques de circuits imprimés selon la revendication 6 ou la revendication 7, dans lequel on place un mélange de sulfure de polyphénylène pulvérulent et de fibres de verre découpées dans un moule dans lequel on comprime le mélange sous chauffage pour provoquer l'obtention d'un ensemble intégré.

9. Procédé pour la préparation de plaques de circuits imprimés selon la revendication 6 ou la revendication 7, dans lequel on place un stratifié, comprenant des fibres de verre hachées interposées entre des feuilles de sulfure de polyphénylène, dans un moule dans lequel on comprime le stratifié sous chauffage de manière à obtenir un ensemble intégré.

10. Procédé pour la préparation de plaques de circuits imprimés selon la revendication 6 ou la revendication 7, dans lequel on répartit uniformément du sulfure de polyphénylène pulvérulent sur un mat, une étoffe tissée ou une étoffe tricotée de fibres de verre, et l'on place le mat, l'étoffe tissée ou l'étoffe tricotée dans un moule dans lequel le mat ou l'étoffe tissée ou tricotée est comprimé sous pression de manière à obtenir un ensemble intégré.

11. Procédé pour la préparation de plaques de circuits imprimés selon la revendication 6 ou la revendication 7, dans lequel on comprime dans un moule, sous chauffage, un stratifié comprenant un ou plusieurs mats, des étoffes tissées on des étoffes tricotées de fibres de verre et une ou plusieurs feuilles de sulfure de polyphénylène, de façon à obtenir un ensemble intégré.

12. Procédé pour la préparation de plaques de circuits imprimés selon la revendication 6 ou la revendication 7, dans lequel on place le mélange ou stratifié de sulfure de polyphénylène et des fibres de verre entre deux courroies métalliques et on chauffe le mélange en continu sous l'application d'une pression pour effectuer l'intégration.

13. Procédé pour la préparation de plaques de circuits imprimés selon l'une quelconque des revendications 6 à 12, dans lequel on fait adhérer la feuille métallique à la surface de la plaque moulée en même temps qu'on soumet cette plaque à compression sous chauffage.

14. Procédé pour la préparation de plaques de circuits imprimés selon l'une quelconque des revendications 6 à 12, dans lequel on fait adhérer la feuille métallique à la surface de la plaque moulée après la compression sous chauffage.

15. Procédé pour la préparation de plaques de circuits imprimés selon l'une quelconque des revendications 6 à 14, dans lequel la température de chauffage est supérieure au point de fusion du sulfure de polyphénylène.